(19) Europäisches Patentamt / European Patent Office / Office européen des brevets

(11) **EP 1 393 017 B1**

(12) **FASCICULE DE BREVET EUROPEEN**

(45) Date de publication et mention de la délivrance du brevet:
**20.10.2010 Bulletin 2010/42**

(21) Numéro de dépôt: **02740835.0**

(22) Date de dépôt: **28.05.2002**

(51) Int Cl.:
***G01C 19/66*** (2006.01)

(86) Numéro de dépôt international:
**PCT/FR2002/001792**

(87) Numéro de publication internationale:
**WO 2002/097370 (05.12.2002 Gazette 2002/49)**

(54) **GYROMETRE LASER ETAT SOLIDE COMPORTANT UN BLOC RESONATEUR**

FESTKÖRPERLASERKREISEL WELCHER EINEN RESONATORBLOCK ENTHÄLT

SOLID STATE LASER GYROMETER COMPRISING A RESONATOR BLOCK

(84) Etats contractants désignés:
**DE FR GB IT**

(30) Priorité: **30.05.2001 FR 0107266**

(43) Date de publication de la demande:
**03.03.2004 Bulletin 2004/10**

(73) Titulaire: **Thales**
**75008 Paris (FR)**

(72) Inventeurs:
- **POCHOLLE, J.,**
  **c/oThales Intellectual Property**
  **F-94117 Arcueil Cedex (FR)**
- **GALLON, P.,**
  **c/o Thales Intellectual Property**
  **F-94117 Arcueil cedex (FR)**
- **LECLERC, J.,**
  **c/o Thales Intellectual Property**
  **F-94117 Arcueil (FR)**
- **GIRAULT, H.,**
  **c/o Thales Intellectual Property**
  **F-94117 Arcueil cedex (FR)**

(74) Mandataire: **Esselin, Sophie**
**Marks & Clerk France**
**Conseils en Propriété Industrielle**
**Immeuble " Visium "**
**22, avenue Aristide Briand**
**94117 Arcueil Cedex (FR)**

(56) Documents cités:
**US-A- 5 241 555   US-A- 5 241 555**
**US-A- 5 367 377   US-A- 5 960 022**

**Description**

La présente invention se rapporte à un gyromètre laser état solide comportant un bloc résonateur.

On connaît des gyromètres monolithiques, par exemple d'après le brevet US 5 960 022, utilisant en tant que source laser, un milieu solide. Ce brevet décrit un gyromètre dans lequel la cavité résonante est réalisée en un matériau optique entièrement dopé, ce qui le rend difficile à réaliser si l'on veut qu'il ait des qualités homogènes. D'autre part, ce type de laser utilise un volume non négligeable de matériaux dopés, ce qui le rend onéreux et présente des dérives en fonction des variations de température ambiante.

De même, le document US 5 241 555 décrit un laser dont la cavité résonante est un bloc entièrement réalisé en matériau semi-conducteur, la pastille de milieu à gain étant insérée dans ce bloc

On connaît d'après le document US-A-5 367 377 un gyroscope à cavité non planaire qui, en présence d'un champ magnétique, permet d'obtenir quatre modes de cavité contrapropagatifs, ce qui permet de réaliser un gyrolaser à double cavité. La cavité décrite dans ce document, étant non plane, est difficile à fabriquer et à régler (l'alignement des différents éléments optiques de la cavité est critique). De plus, la présence dans la cavité d'un élément sensible aux champs magnétiques oblige à prévoir un blindage très efficace de la cavité, qui est très coûteux. Le milieu à gain est disposé dans un des bras de la cavité en anneau, ce qui en complique la fabrication.

La présente invention a pour objet un gyromètre laser à état solide qui soit facile à réaliser, peu onéreux, utilisant un petit volume de matériau actif, et qui soit stable en température.

Le gyromètre laser conforme à l'invention comporte un bloc résonateur état solide planaire dans lequel est défini un trajet optique suivi par deux ondes contra-rotatives engendrées par un milieu laser à gain optique, caractérisé par le fait que le bloc résonateur est en matériau passif non dopé et que le milieu à gain est directement fixé sur une face latérale du bloc résonateur.

Selon un aspect préféré de l'invention, ce bloc comporte des canaux optiques usinés. Le milieu à gain est un cristal dopé aux terres rares et pompé par diode laser. En variante, ce milieu à gain peut être pompé directement par voie électrique.

La présente invention sera mieux comprise à la lecture de la description détaillée de plusieurs modes de réalisation, pris à titre d'exemples non limitatifs et illustrés par le dessin annexé, sur lequel:

- les figures 1 et 2 sont des schémas de principe de structure de gyromètre laser conformes à l'invention,
- la figure 3 est une vue en plan simplifiée d'une structure de gyromètres conforme à l'invention,
- les figures 4 et 5 sont des vues simplifiées de dispositifs de pompage optique pouvant être utilisés dans le gyromètre de l'invention,

- les figures 6 et 7 sont des diagrammes d'évolution de la puissance d'oscillation laser émise en fonction de la puissance de pompage incidente et du coefficient de réflexion du miroir de sortie, pour des épaisseurs différentes de la structure conforme à l'invention, et
- La figure 8 est une vue en plan simplifié d'une variante de la structure conforme à l'invention.

Le dispositif gyromètre laser conforme à l'invention exploite les propriétés d'émission laser des terres rares lorsqu'elles sont insérées dans une matrice hôte définissant une cavité optique et sont excitées par un processus de pompage optique.

On va rappeler ici quelques notions de base relatives aux gyromètres à cavité en anneau. Lorsqu'une cavité est immobile, la pulsation $\omega_m$ du champ associée à un mode longitudinal est obtenue par la relation :

$$\omega_m . L/C = 2\pi m$$

Dans cette relation, $L$ est la longueur du périmètre de la cavité, C la vitesse de la lumière dans le milieu présent dans la cavité et m le nombre entier de longueurs d'onde $\lambda_m$ contenues dans un périmètre de cavité, m étant tel que :

$$\left( \frac{L}{\lambda_m} = m \right)$$

On a alors :

$$\omega_m = 2\pi m c / L$$

Si la cavité est animée d'un mouvement de rotation de vitesse angulaire $\Omega$ autour d'un axe perpendiculaire au plan principal de la cavité et passant par son centre, les ondes co-propagatives et contra-propagatives (tournant dans le même sens que la cavité) et en sens contraire, respectivement) subissent l'effet Sagnac.

Cet effet est équivalent à une modification de la distance parcourue par les deux ondes (distance augmentée de $\delta L$ pour l'onde co-propagative et diminuée de $\delta L$ dans l'autre sens). Cet effet s'accompagne d'une modification des pulsations associées aux ondes selon leur sens de propagation dans la-cavité (augmentation de la pulsation $\omega_m^-$ dans le sens opposé à celui de la rotation de la cavité,-et diminution de la pulsation $\omega_m^+$ dans le sens de la rotation). On a alors :

$$\omega_m^- - \omega_m^+ = 2\omega_m\, \delta L / L$$

$\delta L$ est proportionnel à la vitesse de rotation $\Omega$ qui, selon la relation de Sagnac, prend la forme :

$$\Delta\omega = \omega_m^- - \omega_m^+ = 4S\, \omega_m\, \Omega / L$$

S étant la surface circonscrite par l'anneau que forme la cavité et *L* étant la longueur de cet anneau.

A partir de cette relation, on peut définir un facteur d'échelle F tel que :

$$F = \Delta\omega / \Omega = 4S\omega / Lc = 8\pi\, S / \lambda\, L$$

Ainsi, en faisant interférer les deux ondes qui parcourent en sens opposés l'anneau résonateur, on peut obtenir un signal de battement lié au décalage en fréquence induit par la rotation de la cavité laser.

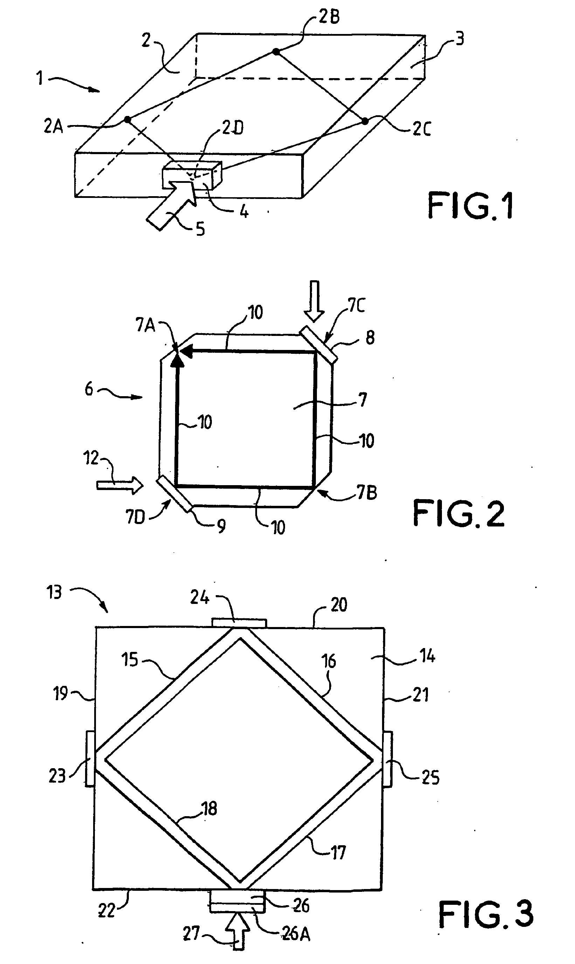

On a représenté en figure 1 le schéma de principe d'un gyromètre laser 1 réalisé entièrement en composants état solide. La cavité 2 est planaire et de forme annulaire rectangulaire. Elle est réalisée dans un bloc optique 3 en forme de plaque rectangulaire de faible épaisseur (quelques millimètres par exemple), alors que les autres dimensions du bloc sont nettement plus grandes (de l'ordre de 10 cm ou plus par exemple).Les quatre sommets du rectangle formé par la cavité coïncident avec les centres des faces latérales du bloc. Trois de ces sommets 2A, 2B, 2C, sont tels qu'il y a réflexion totale des faisceaux laser parcourant la cavité, le quatrième sommet 2D comporte un pavé 4 en matériau dopé par des terres rares à gain optique, directement fixé sur la face latérale correspondante du bloc 3, et associé à un dispositif 5 de pompage optique à composant à état solide également.

On a représenté en figure 2 le schéma de principe d'une variante de réalisation 6 du gyromètre de la figure 1. Ce gyromètre 6 est réalisé à partir d'un bloc 7 de matériau optique, dont l'épaisseur est également faible par rapport à ses autres dimensions. Ce bloc a une forme de parallélépipède rectangle dont les quatre coins latéraux sont supprimés. Deux des surfaces opposées 7A, 7B ainsi créées restent nues, tandis que l'on munit les deux autres surfaces 7C et 7D de pavés 8 et 9 en matériau semi-conducteur ou de type cristal diélectrique dopé par des terres rares, formant milieu actif à gain optique. Une cavité optique 10 annulaire est formée entre les centres successifs des surfaces 7A, 7C, 7B -et 7D. On obtient ainsi une structure symétrique (par rapport aux diagonales joignant les centres des surfaces 7A, 7B et 7C, 7D).

Des dispositifs de pompage 11 et 12 sont associés aux pavés 8 et 9 respectivement. Ces dispositifs 11 et 12 sont disposés symétriquement par rapport à la diagonale reliant les milieux des surfaces 7A, 78, de façon à attaquer les chemins optiques partant de ces centres en sens contraires.

On a représenté en figure 3 un mode de réalisation de gyromètre laser reprenant le principe de la figure 1. Ce gyromètre 13 est réalisé à partir d'un bloc 14 en matériau à très faible coefficient de dilatation thermique, par exemple du "ZERODUR(™)". Dans ce bloc 14, on usine quatre fins canaux 15 à 18 joignant respectivement les centres des faces latérales consécutives 19 à 22 de ce bloc. Ces canaux ont par exemple une section cylindrique d'un diamètre d'environ 1 mm. Sur les centres des faces 19 à 21, on fixe les miroirs 23 à 25, et sur le centre de la face 22, on fixe un "miroir actif" 26,qui est constitué par une ou plusieurs plaquettes de matériau laser solide, par exemple du Nd $^{3+}$ : YVO$_4$. Cette plaquette (ou ensemble de plaquettes) présente sur sa face opposée à celle-qui est appliquée contre le bloc 14 un miroir ayant un coefficient de réflexion maximal à la longueur d'onde d'oscillation dans la cavité en anneau (constituée par les segments 15 à 18) et pour l'angle d'incidence sur ce miroir imposé par la géométrie de cet anneau. Sur sa face appliquée contre le bloc 14, la plaquette 26 présente un traitement anti-reflets. Cette plaquette 26 est associée à un dispositif de pompage 27.

Grâce à l'emploi de matériau tel que le "Zerodun(™)" pour réaliser le bloc 14, on abaisse le prix de revient du gyromètre et on obtient une excellente stabilité thermo-optique de la cavité, dont la structure est quasi-monolithique. On peut, bien entendu, utiliser des matériaux autres que le "Zerodur" et présentant des qualités similaires, par exemple de la silice fondue. Les canaux 15 à 18 peuvent être remplis d'un gaz neutre à une pression qui est fonction du domaine d'emploi du gyromètre (pression atmosphérique ou différente). Ce gaz peut être de l'air purifié ou de l'azote, par exemple. Le seul critère de choix de ce gaz (ou mélange de gaz neutres) est l'absence de bande d'absorption à la longueur d'onde de travail.

L'invention s'applique également à la réalisation d'un système gyroscopique tri-axe, en associant trois dispositifs tels que décrits ci-dessus et dont les plans sont perpendiculaires entre eux, deux à deux.

Dans tous les modes de réalisation du gyromètre de l'invention, le filtrage spatial ou la sélection de mode laser transverse, peuvent être effectués en modifiant de façon connue en soi le diamètre des canaux 15 à 18 et/ou des caractéristiques du pompage optique 27.

Le matériau laser de la plaquette (ou des plaquettes) 26 est de préférence un cristal uniaxe de vanadate d'yttrium dopé par l'ion de terre rare Vd$^{3+}$.

L'intérêt présenté par ce matériau repose sur les avantages suivants qu'il procure :

- l'émission laser est naturellement polarisée,
- par rapport à des matériaux tels que le grenat d'yttrium (YAG), il présente une plus forte section efficace d'absorption et d'émission, ce qui permet d'obtenir un gain optique important, même pour de faiblies épaisseurs de la micro-plaquette.

- Le spectre du gain (bande passante) relativement étendu (par exemple: largeur de bande de 5 nm environ à une longueur d'onde de 1,064 nm environ) permet de faire fonctionner le laser en mode impulsionnel,

- La largeur spectrale de la bande d'absorption réduit la sensibilité à une dérive en longueur d'onde de la diode laser de pompage. A titre indicatif, le coefficient d'absorption à la longueur d'onde de pompage de 808 nm est de 30cm⁻¹. Dans un tel cas, l'épaisseur de la micro plaquette doit être de l'ordre de 300 µm.

On peut également utiliser pour réaliser les micro-plaquettes 26 un cristal Nd : YAG à la longueur d'onde d'oscillation de 1,064 nm. Dans ce cas, on peut effectuer un dopage de ce cristal avec 1.1 % atomique de Nd³⁺, ce qui permet d'obtenir un coefficient de gain optique élevé pour une faible épaisseur de cristal. Typiquement, le coefficient d'absorption est alors de 6 cm⁻¹, ce qui donne une épaisseur de Nd : YAG d'environ 1.5 mm. Il est également possible d'envisager l'emploi d'une plaquette de verre co-dopée Yb : Er, permettant de réaliser un oscillateur à 1,54 µm.

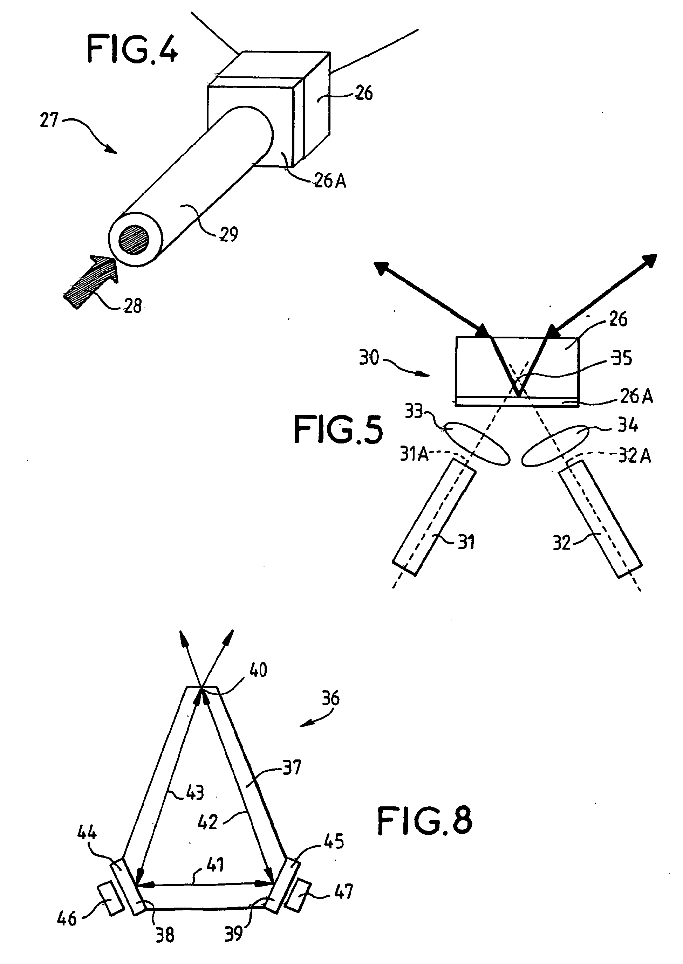

On a représenté en figure 4 le schéma de principe du dispositif 27 permettant le pompage longitudinal par fibre optique de la micro-plaquette 26 de la figure 3. A cet effet, la pompe 28 (une ou plusieurs diodes laser) attaque une fibre optique multimode unique 29 qui aboutit à la partie 26A formant miroir de la plaquette 26.

Selon la variante de la figure 5 le dispositif 30 permettant le pompage optique de la plaquette 26, comporte deux fibres optiques 31 et 32 couplées à travers des lentilles convergentes 33 et 34 respectivement, à cette plaquette 26. Les axes de sortie 31 A. 32A des fibres 31, 32 sont orientés de façon à converger en un point 35 tel qu'une énergie optique maximale soit injectée dans les canaux aboutissant à la plaquette 26 (canaux 17 et 18 de la figure 3). Ainsi, on optimise l'intégrale de recouvrement entre le mode de la cavité et la distribution spatiale de l'énergie de pompage (c'est-à-dire du gain). Ce dispositif 30 permet également d'assurer un filtrage spatial du mode de cavité lorsque celle-ci oscille, grâce à cette optimisation des intégrales de recouvrement.

Dans le cas de la cavité en anneau de la figure 2, on peut évaluer les niveaux de puissance de pompage qu'il est nécessaire de mettre en oeuvre pour obtenir l'oscillation laser. Selon un exemple de réalisation, on considère une cavité en anneau dont chaque canal (faisant partie des canaux référencés 10 en figure 2) a une longueur (optique) de 10 cm, les miroirs formés aux quatre coins de bloc optique 7 ayant un rayon de courbure de 1 m.

Les dimensions du faisceau gaussien associé au mode fondamental $TEM_{00}$ dans un tel résonateur sont respectivement de 247,8 µm dans le plan du résonateur et de 297 µm dans le plan perpendiculaire au premier.

Ces grandeurs correspondent au rayon du col dudit mode fondamental ("waist" en anglais).

Au niveau des miroirs, les dimensions du rayon du mode sont respectivement de 257 et 303 µm.

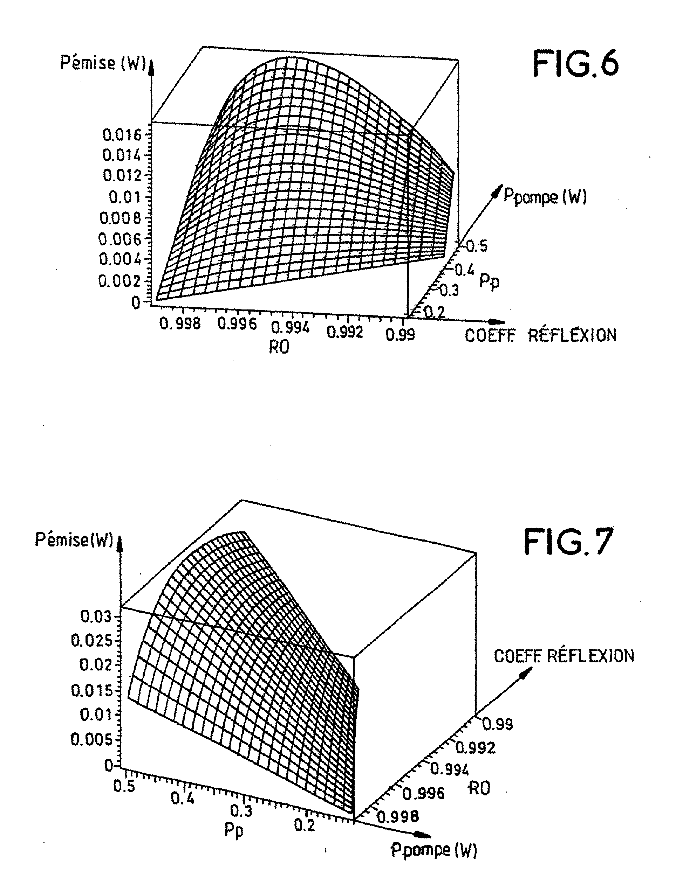

On va maintenant examiner, en référence aux figures 6 et 7, comment évolue la puissance laser émise dans l'anneau en fonction des différents paramètres du dispositif de l'invention.

L'exemple de la figure 6 se rapporte à un bloc de cristal (tel que le bloc 14 de la figure 3) en Nd : $YVO_4$ d'une épaisseur de 500 µm revêtu d'un traitement Rmax (assurant une réflexion maximale à la longueur d'onde laser du travail) sur une de ses grandes faces et d'un traitement anti-reflets sur l'autre grande face, et ce pour une incidence à 45° du faisceau laser. Le traitement Rmax (pour une longueur d'onde de 1,064 µm) doit être également adapté pour que le faisceau de pompage ( à 0,808 µm dans le présent exemple) puisse être efficacement couplé au milieu actif (micro-plaquette 26 en figure 3). On peut évaluer l'évolution de la puissance de pompage incidente de seuil (puissance minimale nécessaire pour entretenir l'oscillation laser) en fonction du coefficient de réflexion du miroir de sortie (miroir 24). On admet que les pertes sur le trajet optique (pertes au niveau des miroirs-relais.Rmax 23 et 25 et pertes par diffraction) sont de 0.5%. Le réseau de courbes de la figure 6 représente la variation de la puissance laser émise en Watts (oscillation laser) en fonction de la puissance de pompage (également en Watts)-et du coefficient de réflexion du miroir de sortie, la longueur de l'anneau formant cavité étant de 40 cm (quatre canaux successifs de 10 cm de long chacun).

La figure 7 se rapporte à une structure similaire à celle relative à la figure 6, la seule différence étant que le cristal de Nd : $YVO_4$ a une épaisseur de 1 mm.

Les courbes des figures 6 et 7 permettent de se rendre compte de l'évolution du rendement différentiel externe (tel que vu de la pompe) en fonction du niveau de puissance de la pompe et du coefficient de réflexion du miroir de sortie. Le rendement global est de l'ordre de 10%. Ceci est dû à la dimension du mode de cavité (mode fondamental $TEM_{00}$) qui est relativement importante et imposée -par la longueur de chacun de bras du résonateur.

En effet, le facteur d'échelle F pour une cavité annulaire à contour carré est donné par la relation :

$$F = 2\pi L_{cav} / \lambda$$

$L_{cav}$ étant la longueur totale de la cavité. Ainsi, par exemple, si $L_{cav} = 40$cm et $\lambda = 1,064$ µm, on obtient $F = 2,36.10^6$.

En augmentant le rayon de courbure des miroirs (23 à 25 et 26A), il est possible de réduire la dimension du mode de cavité.

Ainsi, en optimisant la dimension de la zone de micro-plaquette pompée, on peut minimiser la puissance optique de pompage à mettre en oeuvre.

L'intérêt du dispositif de l'invention pour le gyromètre laser réside dans le fait que l'alimentation d'une diode laser de pompage nécessite une tension électrique qui est de l'ordre de grandeur de l'énergie de bande interdite du composé semiconducteur employé. Typiquement, à la longueur d'onde de 0.8 $\mu$m, cette tension est d'environ 1,5 V. Seule l'injection de courant dans la diode laser régule le niveau de puissance optique délivrée. Le rendement de conversion optique/électrique est typiquement d'environ 50%. Ainsi, si le niveau de puissance de pompe nécessaire pour entretenir l'oscillation laser est de 500 mW, la puissance électrique consommée est d'environ 1 W.

Dans le cas de l'utilisation d'une diode laser unique de pompage, celle-ci peut être couplée directement (par contact physique) ou par l'intermédiaire d'une micro-optique de type "lentille cylindrique" (semi-cylindrique) permettant de corriger la divergence du faisceau de pompage émis dans une direction perpendiculaire à la jonction.

Si la longueur d'onde de fonctionnement se situe dans le proche infrarouge (environ 1 $\mu$m), on réduit les effets de diffusion au niveau des miroirs, si cette diffusion est gouvernée par un processus de type Rayleigh, ce qui, toutefois, entraîne une réduction du phénomène d'accumulation de phase dans un montage interférométrique.

On a présenté en figure 8 le schéma de principe d'une structure 36 de gyromètre dont la cavité en anneau a une forme triangulaire. Le bloc optique 37 dans lequel est formée la cavité optique est une plaque optique à contour en forme de triangle isocèle ou équilatéral dont les trois sommets ont été supprimés de telle façon que les petites surfaces latérales 38, 39 et 40 ainsi dégagées soient perpendiculaires aux bissectrices des angles du triangle. Trois canaux 41, 42 et 43 sont percés dans ce bloc pour former la cavité, ces canaux joignant respectivement les centres des surfaces 38 à 40. Sur deux des faces, par exemple 38 et 39, on fixe une plaquette de milieu actif (telle la plaquette 26), respectivement 44, 45. Chacune de ces deux plaquettes est associée à une diode laser de pompage, 46, 47 respectivement.

Dans tous les modes de réalisation décrits ci-dessus, on peut utiliser en tant que milieu actif une ou plusieurs microplaquettes de matériaux semiconducteurs excités directement par injection de porteurs. En variante, on peut utiliser une diode laser semi- VCSEL, dans laquelle le miroir de Bragg externe est remplacé par un traitement anti-reflets. Dans ce cas, ce composant fait office de zone à gain, et le résonateur impose les conditions de filtrage spatial et fréquentiel.

Le dispositif de l'invention permet de réduire le coût d'un gyromètre laser et d'en simplifier considérablement la conception et la fabrication . A partir de composés GaInAlP à puits quantiques opérant à une longueur d'onde d'environ 0,65$\mu$m, le gain en sensibilité lié à l'emploi d'une courte longueur d'onde permet de réaliser des gyromètres optiques tout-état solide. Si l'on utilise des matériaux et des structures dont la courbe de gain s'adapte à la longueur d'onde du laser à gaz He-Ne fonctionnant à une longueur d'onde de 0,6328$\mu$m, on peut conserver les technologies utilisées pour les miroirs des cavités.

## Revendications

1. Gyromètre laser état solide comportant un bloc résonateur état solide planaire (3, 7, 14, 37) dans lequel est défini un trajet optique (2, 10, 15 à 18, 41 à 43) suivi par deux ondes contra-rotatives engendrées par un milieu laser à gain optique (4, 8-9, 26, 46-47), **caractérisé par le fait que** le bloc résonateur est en matériau passif non dopé et que le milieu à gain (4, 8, 9, 26, 44, 45) est directement fixé sur une face latérale du bloc résonateur.

2. Gyromètre laser état solide selon la revendication 1, **caractérisé par le fait que** le bloc résonateur est un bloc de matériau passif dans lequel sont usinés des canaux.

3. Gyromètre laser état solide selon l'une des revendications précédentes, **caractérisé par le fait que** le milieu à gain comporte un matériau à émission préférentiellement polarisée et est pompé par une source laser (5, 11-12, 28, 46-47).

4. Gyromètre laser état solide selon la revendication 3, **caractérisé par le fait que** le milieu à gain est un cristal dopé aux terres rares.

5. Gyromètre laser état solide selon la revendication 3 ou 4, **caractérisé par le fait que** le milieu à gain est un semi-conducteur pompé directement par voie électrique.

6. Gyromètre laser état solide selon l'une des revendications 3 ou 4, **caractérisé par le fait que** le milieu à gain est un cristal uniaxe de vanadate d'Yttrium dopé par l'ion terre rare $Nd^{3+}$.

7. Gyromètre laser état solide selon l'une des revendications 1 à 5, **caractérisé par le fait que** le milieu à gain est du Nd:YAG.

8. Gyromètre laser état solide selon l'une des revendications précédentes, **caractérisé par le fait que** le bloc résonateur est en matériau à faible coefficient de dilatation thermique.

9. Gyromètre laser état solide selon l'une des revendications précédentes, **caractérisé par le fait que** le bloc résonateur en "ZERODUR"$^{(TM)}$.

**10.** Système gyroscopique tri-axe **caractérisé par le fait qu'**il comporte trois gyromètres selon l'une des revendications précédentes, dont les plans sont perpendiculaires entre eux, deux à deux.


## Claims

1. A solid-state laser gyrometer comprising a planar solid-state resonator block (3, 7, 14, 37) in which an optical path (2, 10, 15 to 18, 41 to 43) is defined followed by two counter-rotating waves generated by an optical gain laser medium (4, 8-9, 26, 46-47), **characterised in that** the resonator block is made from non-doped passive material and **in that** the medium with gain (4, 8, 9, 26, 44, 45) is attached directly to a lateral surface of the resonator block.

2. The solid-state laser gyrometer according to claim 1, **characterised in that** the resonator block is a block of passive material having channels machined therein.

3. The solid-state laser gyrometer according to any one of the previous claims, **characterised in that** the medium with gain includes an emitting material which is preferably polarised and which is pumped by a laser source (5, 11-12, 28, 46-47).

4. The solid-state laser gyrometer according to claim 3, **characterised in that** the medium with gain is a rare-earth-doped crystal.

5. The solid-state laser gyrometer according to claims 3 or 4, **characterised in that** the medium with gain is a semi-conductor pumped directly by electrical means.

6. The solid-state laser gyrometer according to claims 3 or 4, **characterised in that** the medium with gain is an Yttrium vanadate single-axis crystal doped with the rare earth ion Nd3+.

7. The solid-state laser gyrometer according to any one of claims 1 to 5, **characterised in that** the medium with gain is Nd:YAG.

8. The solid-state laser gyrometer according to any one of the preceding claims, **characterised in that** the resonator block is made from material having a low thermal expansion coefficient.

9. The solid-state laser gyrometer according to any one of the previous claims, **characterised in that** the resonator block is made from "ZERODUR" ™.

10. A three-axis gyroscopic system, **characterised in that** it includes three gyrometers according to any one of the preceding claims, wherein the planes are arranged perpendicularly to each other, in a pairwise manner.


## Patentansprüche

1. Festkörperlaser-Gyrometer, der einen ebenen Festkörper-Resonatorblock (3, 7, 14, 37) umfasst, in dem ein Lichtweg (2, 10, 15 bis 18, 41 bis 43) definiert ist, gefolgt von zwei gegenläufigen Wellen, die von einem optisch verstärkten Lasermedium (4, 8-9, 26, 46-47) erzeugt werden, **dadurch gekennzeichnet, dass** der Resonatorblock aus einem nichtdotierten passiven Material besteht, und **dadurch,** dass das verstärkte Medium (4, 8, 9, 26, 44, 45) direkt an einer lateralen Fläche des Resonatorblocks befestigt ist.

2. Festkörperlaser-Gyrometer nach Anspruch 1, **dadurch gekennzeichnet, dass** der Resonatorblock ein Block aus passivem Material ist, in den Kanäle eingearbeitet sind.

3. Festkörperlaser-Gyrometer nach einem der vorherigen Ansprüche, **dadurch gekennzeichnet, dass** das verstärkte Medium ein vorzugsweise polarisiert emittierendes Material beinhaltet, das von einer Laserquelle (5, 11-12, 28, 46-47) gepumpt wird.

4. Festkörperlaser-Gyrometer nach Anspruch 3, **dadurch gekennzeichnet, dass** das verstärkte Medium ein mit seltenen Erden dotierter Kristall ist.

5. Festkörperlaser-Gyrometer nach Anspruch 3 oder 4, **dadurch gekennzeichnet, dass** das verstärkte Medium ein Halbleiter ist, der direkt auf elektrischem Weg gepumpt wird.

6. Festkörperlaser-Gyrometer nach Anspruch 3 oder 4, **dadurch gekennzeichnet, dass** das verstärkte Medium ein einachsiger Yttriumvanadat-Kristall ist, der mit dem Seltenerdion Nd3+ dotiert ist.

7. Festkörperlaser-Gyrometer nach einem der Ansprüche 1 bis 5, **dadurch gekennzeichnet, dass** das verstärkte Medium Nd:YAG ist.

8. Festkörperlaser-Gyrometer nach einem der vorherigen Ansprüche, **dadurch gekennzeichnet, dass** der Resonatorblock aus einem Material mit einem niedrigen Wärmeausdehnungskoeffizienten ist.

9. Festkörperlaser-Gyrometer nach einem der vorherigen Ansprüche, **dadurch gekennzeichnet, dass** der Resonatorblock aus "ZERODUR" ™ ist.

10. Dreiachsiges gyroskopisches System, **dadurch gekennzeichnet, dass** es drei Gyrometer nach einem der vorherigen Ansprüche umfasst, wobei die Ebenen paarweise lotrecht zueinander sind.

FIG.1

FIG.2

FIG.3

FIG.4

27

26

26A

29

28

30

26

35

26A

FIG.5

33

34

31A

32A

31

32

40

36

37

43

42

FIG.8

44

45

41

46

47

38

39

FIG.6

FIG.7

**EP 1 393 017 B1**

**RÉFÉRENCES CITÉES DANS LA DESCRIPTION**

**Documents brevets cités dans la description**

- US 5960022 A
- US 5241555 A
- US 5367377 A